# FASCICULE DE BREVET EUROPEEN

(11) **EP 0 860 872 B1**
(45) Date de publication et mention de la délivrance du brevet: **15.05.2002**
(21) Numéro de dépôt: 97102650.5
(22) Date de dépôt: 19.02.1997
(51) Int. Cl.: H01L 21/66

(54) **Plaquette à gravure comprenant des circuits optoélectroniques et des circuits de test, et procédé de vérification de cette plaquette**
Scheibe mit opto-elektronischen Schaltkreisen und Testschaltkreisen, und Verfahren zum Testen der Scheibe
Wafer with opto-electronic circuits and test circuits, and method of testing said wafer

(43) Date de publication de la demande: 26.08.1998
(73) Titulaire: EM Microelectronic-Marin SA, 2074 Marin (CH)
(72) Inventeur: Grandjean, André, 2088 Cressier (CH); Kunz, Pascal, 2000 Neuchâtel (CH)
(74) Mandataire: Balsters, Robert

(56) Documents cités:
- PATENT ABSTRACTS OF JAPAN vol. 095, no. 004, 31 Mai 1995 & JP 07 029956 A (FUJITSU LTD;OTHERS: 01), 31 Janvier 1995,
- PATENT ABSTRACTS OF JAPAN vol. 018, no. 295 (P-1748), 6 Juin 1994 & JP 06 059167 A (NIPPON TELEGR & TELEPH CORP), 4 Mars 1994,
- PATENT ABSTRACTS OF JAPAN vol. 014, no. 359 (E-0959), 3 Août 1990 & JP 02 125635 A (NEC CORP), 14 Mai 1990,
- PATENT ABSTRACTS OF JAPAN vol. 009, no. 263 (E-351), 19 Octobre 1985 & JP 60 110132 A (SHARP KK), 15 Juin 1985,
- RESEARCH DISCLOSURE, no. 293, Septembre 1988, page 659 XP000039419 "THIRD LEVEL METAL DIAGNOSTIC IMAGE"

## Description

La présente invention concerne une plaquette à gravure, c'est-à-dire une plaquette sur laquelle sont gravées notamment des circuits optoélectroniques. L'invention concerne également un procédé de vérification des circuits de cette plaquette.

On a déjà proposé de plaquettes comprenant des circuits optoélectroniques. En général, une telle plaquette comprend plusieurs milliers de circuits intégrés. Chaque circuit comporte entre autres au moins une plage de connexion pour permettre l'accès vers un appareil de mesure externe.

Les procédés de vérification connus de ces circuits sur la plaquette utilisent ces plages de connexion pour vérifier le fonctionnement de chaque circuit afin de déterminer le résultat de fabrication de la plaquette. Typiquement, plusieurs circuits sont testés, de l'ordre de 1 sur 20, et si le résultat de vérification des circuits qui fonctionnent correctement est au-dessus d'un seuil prédéterminé, par exemple 93 % des circuits testés, on estime que les autres circuits non testés fonctionnent également correctement, et la vérification de la plaquette est arrêtée. Par contre, si le résultat descend en dessous de ce seuil prédéterminé, les autres circuits subissent également chacun une vérification individuelle afin de vérifier s'ils fonctionnent correctement ou pas.

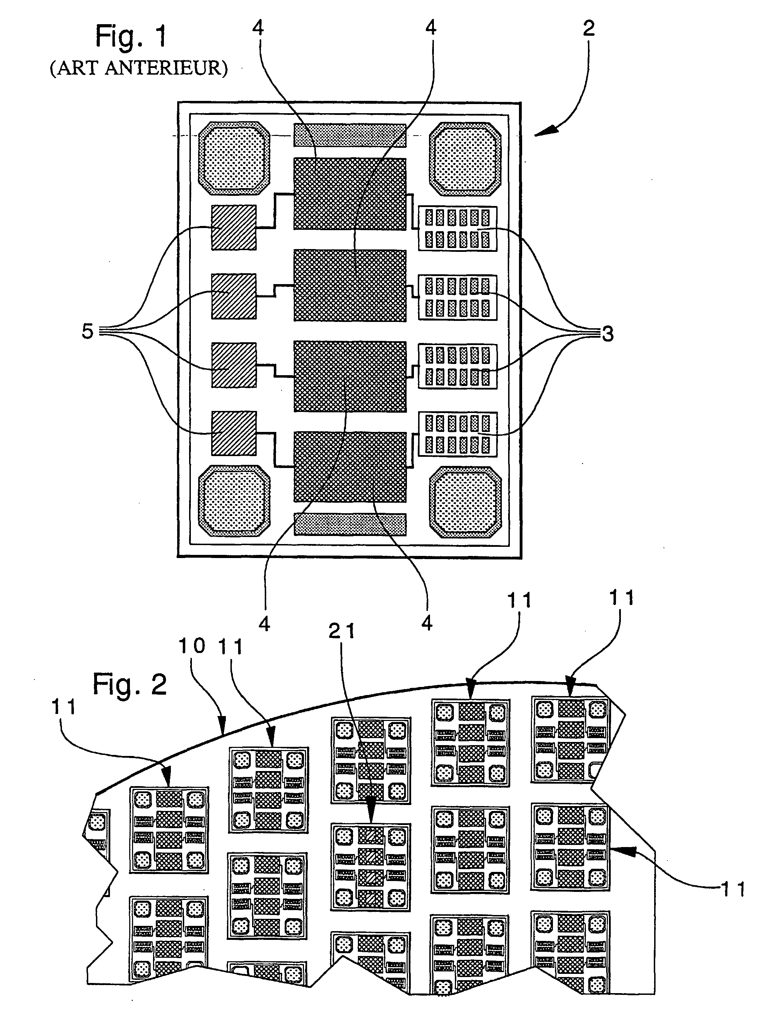

En fait, comme le montre la figure 1, chaque circuit optoélectronique intégré, désigné par la référence 2, comporte habituellement des blocs fonctionnels 3, des photodiodes 4 et plusieurs plages de connexion 5 afin de pouvoir le connecter à des appareils externes, non représentées, qui envoient des signaux de mesures pour effectuer des essais sur le circuit afin de vérifier que ce circuit fonctionne correctement. Toutefois, ces plages de connexion occupent une place importante sur la plaquette ce qui limite le nombre de circuits intégrés pouvant être fabriqué sur une seule plaquette et augmente donc le prix de fabrication de chaque circuit.

Toutefois, la Demanderesse de la présente demande de brevet a constaté que seules un très faible pourcentage de plaquettes ne passent pas la première étape du procédé de vérification décrit ci-dessus, pourcentage se situant autour de 1 à 2 % des plaquettes d'une même série.

Un but de la présente invention est de remédier aux inconvénients susmentionnés en fournissant une plaquette à gravure comportant des circuits optoélectroniques intégrés, qui nécessite moins de place pour les plages de connexion, et qui laisse donc plus de place disponible pour les circuits intégrés de sorte que davantage de circuits peuvent être fabriqué sur une seule plaquette que cela n'était le cas pour les plaquettes de l'art antérieur.

Un autre but de la présente invention est de fournir un procédé de vérification qui assure une vérification correcte et efficace d'une telle plaquette.

Ces buts sont atteints grâce aux caractéristiques particulières que présente la plaquette de la revendication 1 ainsi que le procédé de la revendication 4.

En effet, un nombre très réduit de circuits de test est prévu sur la plaquette. Seules ces circuits comportent des plages de connexion pour la vérification. Ces circuits ne peuvent être utilisés normalement, et sont donc "sacrifiés" à cet effet. Les autres circuits ne comportant pas de plages de connexion pour la vérification, ils occupent moins de place sur la surface de la plaquette si bien qu'un plus grand nombre de circuits intégrés peut être fabriqué sur une seule plaquette.

D'autres caractéristiques et avantages de la présente invention seront rendus évidents par la description qui va suivre, qui est donnée à titre d'exemple uniquement, et qui sera faite à l'aide des dessins annexés dans lesquels:
- la figure 1 déjà décrite montre schématiquement un circuit optoélectronique intégré dans une plaquette selon l'art antérieur,
- la figure 2 est une vue partielle et schématique d'une plaquette selon l'invention comprenant plusieurs circuits optoélectroniques intégrés d'un premier type et au moins un circuit optoélectronique intégré d'un deuxième type,
- la figure 3 montre schématiquement le circuit optoélectronique intégré du premier type de la figure 2, et
- la figure 4 montre schématiquement le circuit optoélectronique intégré du deuxième type de la figure 2.

La figure 2 montre une plaquette à gravure, c'est-à-dire une plaquette sur laquelle sont gravée notamment des circuits optoélectroniques, selon l'invention. La plaquette 10 comporte plusieurs circuits intégrés, typiquement plusieurs milliers de circuits, qui sont fabriqués au même moment. La plaquette selon l'invention comporte deux types de circuits intégrés distincts, comme cela sera expliqué ci-après.

En effet, la plaquette 10 comprend plusieurs circuits optoélectroniques intégrés d'un premier type 11 et au moins un circuit optoélectronique intégré d'un deuxième type 21.

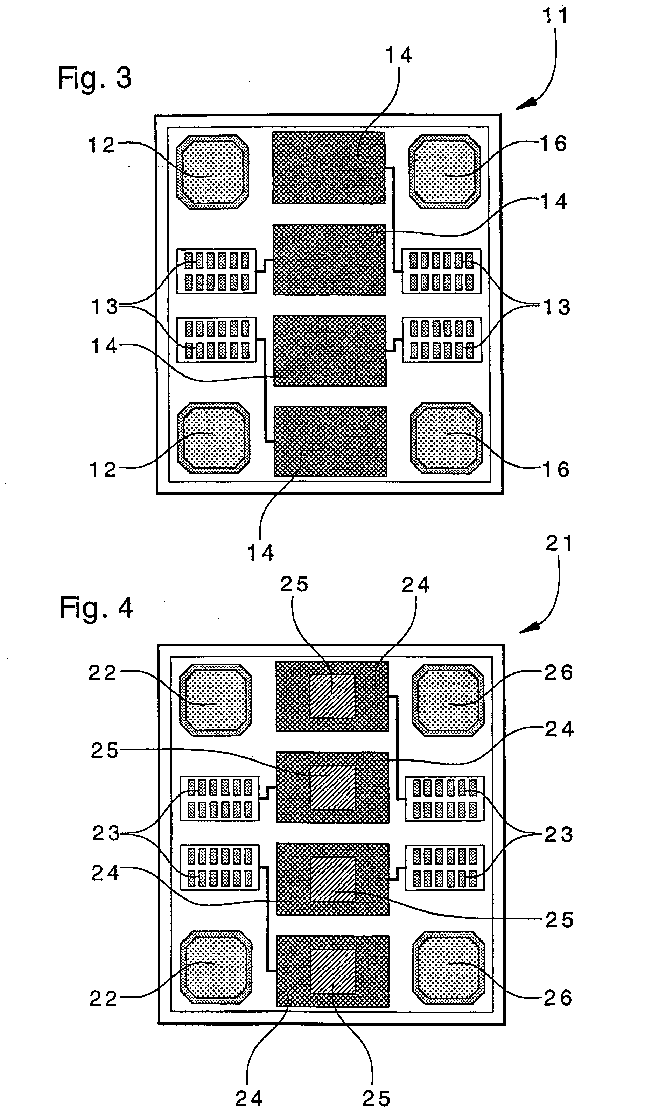

Le circuit optoélectronique intégré du premier type 11 est représenté schématiquement à la figure 3 et comprend, d'une façon connue, des bornes d'alimentation 12 et des blocs fonctionnels 13 qui sont interconnectés. Des capacités 16 faisant partie des blocs fonctionnels 13 peuvent également être prévues. Le circuit du premier type 11 comprend en outre au moins une photodiode 14 reliée aux blocs fonctionnels 13. On remarquera que le circuit du premier type 11 ne contient pas de plage de connexion permettant l'accès à des appareils de mesure externes.

Le circuit du deuxième type 21 est représenté schématiquement à la figure 4 et comprend également des bornes d'alimentation 22, des blocs fonctionnels 23 interconnectés, des capacités 26, le cas échéant, ainsi qu'au moins une photodiode 24 reliée aux blocs fonctionnels 23. Le circuit du deuxième type 21 comprend en outre au moins une plage de connexion permettant de relier le circuit du deuxième type 21 à un appareil de mesure externe pour la vérification. Ceci peut être effectué d'une façon classique comme cela a été expliqué ci-dessus. Dans l'exemple, le circuit du deuxième type 21 comprend quatre photodiodes 24 et quatre plages de connexion 25. Toutefois, ces plages de connexion 25 sont superposées sur les photodiodes 24. En fait, le masque de gravure utilisé pendant la fabrication de la plaquette a été modifiée afin d'ajouter une plage de connexion sur chaque photodiode de chacun de ces circuits du deuxième type. De préférence, le rapport entre un circuit du deuxième type 21 et un circuit du premier type 11 est de 1 sur 35, c'est-à-dire qu'il y a 35 fois plus de circuits du premier type que du deuxième type. Bien entendu, il est également possible de choisir un autre rapport entre les circuits du premier et du deuxième type. En effet, la Demanderesse a constaté qu'un rapport de, par exemple, 1 sur 56 donne également des résultats satisfaisants. Comme les photodiodes 14 et 24 sont connectées aux blocs fonctionnels 13 respectivement 23 afin d'assurer le fonctionnement désiré, les plages de connexion 25 qui sont superposées sur les photodiodes 24 vont pouvoir lier ces blocs fonctionnels 23 à un appareil de mesure externe de sorte que le fonctionnement de tous les composants et de leurs interconnections peut être contrôlé.

Comme les circuits du premier type 11 ne comportent pas de plages de connexion externes, la place occupée par chaque circuit du premier type 11 est réduite, de l'ordre de 30 %, par rapport aux circuits connus de l'art antérieur. En fait la surface d'un premier circuit 11 est d'environ 0,69 mm². Et comme les plages de connexion 25 des circuits du deuxième type 21 sont superposées sur les photodiodes 24 de ces circuits du deuxième type 21, ces derniers n'occupent pas plus de place que les circuits du premier type 11. En effet, dans l'exemple décrit, on voit que les circuits intégrés de la plaquette selon l'invention sont moins longs, car les bornes d'alimentation ainsi que les capacités ont pu être placés plus proche des photodiodes à cause d'une meilleure répartition des blocs fonctionnels. Ainsi, il est possible de fabriquer autour de 20'500 circuits sur une plaquette tandis que les plaquettes de l'art antérieur ne pouvaient contenir que 15'000 circuits. Même si on accepte que les circuits du deuxième type 21 sont en effet sacrifiés, parce qu'ils ne sont utilisés que pour la vérification de fabrication de la plaquette, il y a toujours d'environ 20'000 circuits du premier type par plaquette qui peuvent être utilisés normalement.

On comprend qu'ainsi le prix par circuit peut être considérablement réduit par rapport aux circuits de l'art antérieur, dans l'exemple cette réduction est de l'ordre de 30 %.

Le procédé de vérification d'une plaquette selon l'invention consiste à connecter, d'une manière qui est connue en soi, les plages de connexion 25 des circuits du deuxième type 21 à un appareil de mesure externe qui peut envoyer des signaux de mesure. Un tel appareil est connecté aux plages de connexion 25 de chaque circuit du deuxième type 21, l'un après l'autre.

Ensuite, un signal de mesure est envoyé dans le circuit du deuxième type 21 qui génère un signal de réponse. Ce signal de réponse est comparé à un signal de référence afin de déterminer si le circuit du deuxième type 21 fonctionne correctement. Ici aussi, on peut utiliser un seuil de rendement de l'ordre de 93 % par exemple, comme cela a été expliqué ci-dessus. Si le nombre de circuits du deuxième type 21 fonctionnant correctement est au-dessus de ce seuil, la plaquette est considérée comme étant bonne. Par contre, si le résultat de vérification des circuits du deuxième type n'atteint pas ce seuil, la plaquette ne passe pas la vérification et est considérée comme fausse.

Avantageusement, il est possible de prévoir une étape supplémentaire qui suit après le procédé de vérification. Il s'agit d'une inversion des connexions des plages de connexion 25 aux blocs fonctionnels 23 afin d'éviter toute utilisation involontaire des circuits du deuxième type 21. Ainsi, on peut constater directement que ces circuits du deuxième type ne fonctionnent pas.

Bien qu'un mode préféré de réalisation d'une plaquette et d'un procédé de vérification selon l'invention soit décrit ci-dessus, l'invention n'est pas limitée à ce mode de réalisation spécifique, lequel est donné à titre d'exemple non-limitatif.

## Revendications

1. Plaquette à gravure (10) comprenant plusieurs circuits optoélectroniques intégrés d'un premier type (11), ces circuits d'un premier type comprenant chacun des blocs électroniques fonctionnels (13) et au moins une première photodiode (14), **caractérisé en ce que** ladite plaquette (10) comprend en outre au moins un circuit optoélectronique intégré d'un deuxième type (21) comprenant des blocs électroniques fonctionnels (23), au moins une deuxième photodiode (24) et au moins une plage de connexion (25) destinée à être connectée à un appareil de mesure externe, ladite au moins une plage de connexion (25) étant superposée sur ladite au moins une deuxième photodiode (24) de sorte que ledit au moins un circuit du deuxième type (21) peut être utilisé comme circuit de vérification de la fabrication de ladite plaquette.

2. Plaquette selon la revendication 1, dans laquelle le rapport entre les circuits du premier type (11) et ledit au moins un circuit du deuxième type (21) est de 35 sur 1.

3. Plaquette selon la revendication 1, dans laquelle le rapport entre les circuits du premier type (11) et ledit au moins un circuit du deuxième type (21) est de 56 sur 1.

4. Procédé de vérification d'une plaquette à gravure selon l'une quelconque des revendications précédentes, comprenant les étapes suivantes:
- connecter un appareil de mesure à ladite plaquette (10) à l'intermédiaire de ladite au moins une plage de connexion (25),
- envoyer un signal de mesure dans ledit au moins un circuit du deuxième type (21) afin d'obtenir un signal de réponse,
- comparer le signal de réponse généré par ledit au moins un circuit du deuxième type (21) à un signal de référence,
- déterminer si ladite plaquette (10) fonctionne correctement en vue du résultat de la comparaison.

## Patentansprüche

1. Geätzter Wafer (10), der mehrere integrierte optoelektronische Schaltungen (11) eines ersten Typs umfaßt, wobei diese Schaltungen eines ersten Typs jeweils funktionale elektronische Blöcke (13) und wenigstens eine erste Photodiode (14) umfassen, **dadurch gekennzeichnet, daß** der Wafer (10) außerdem wenigstens eine integrierte optoelektronische Schaltung (21) eines zweiten Typs umfaßt, die wenigstens eine zweite Photodiode (24) und wenigstens einen Anschlußbereich (25), der dazu bestimmt ist, mit einem externen Meßgerät verbunden zu werden, umfaßt, wobei der wenigstens eine Anschlußbereich (25) der wenigstens einen zweiten Photodiode (24) überlagert ist, so daß die wenigstens eine Schaltung (21) des zweiten Typs als Prüfschaltung der Fertigung des Wafers verwendet werden kann.

2. Wafer nach Anspruch 1, bei dem das Verhältnis zwischen den Schaltungen (11) des ersten Typs und der wenigstens einen Schaltung (21) des zweiten Typs 35 zu 1 ist.

3. Wafer nach Anspruch 1, bei dem das Verhältnis zwischen den Schaltungen (11) des ersten Typs und der wenigstens einen Schaltung (21) des zweiten Typs 56 zu 1 ist.

4. Verfahren zum Prüfen eines geätzten Wafers nach einem der vorhergehenden Ansprüche, das die folgenden Schritte umfaßt:
- Verbinden eines Meßgeräts mit dem Wafer (10) über wenigstens einen Anschlußbereich (25),
- Schicken eines Meßsignals in die wenigstens eine Schaltung (21) des zweiten Typs, um ein Antwortsignal zu erhalten,
- Vergleichen des Antwortsignals, das von der wenigstens einen Schaltung (21) des zweiten Typs erzeugt wird, mit einem Referenzsignal,
- Bestimmen, ob der Wafer (10) richtig arbeitet, anhand des Vergleichsergebnisses.

## Claims

1. Wafer (10) comprising several integrated optoelectronic circuits of a first type (11), said circuits of the first type each comprising electronic modules (13) and at least a first photodiode (14), **characterized in that** said wafer (10) further comprises at least one integrated optoelectronic circuit of a second type (21) comprising electronic modules (23), at least one second photodiode (24) and at least one bonding pad (25) arranged to be connected to an external measuring apparatus, said at least one bonding pad (25) being superposed onto said at least one second photodiode (24) so that said at least one circuit (21) of the second type may be used as a circuit for verifying the manufacturing of said wafer.

2. Wafer according to claim 1, wherein the ratio of circuits (11) of the first type to said at least one circuit (21) of the second type is 35:1.

3. Wafer according to claim 1, wherein the ratio of the circuits (11) of the first type to said at least one circuit (21) of the second type is 56:1.

4. Method for verifying a wafer according to any of the preceding claims, comprising the following steps:
- connecting an external measuring apparatus to said wafer (10) via said at least one bonding pad (25),
- sending a measuring signal to said at least one circuit (21) of the second type in order to obtain a response signal,
- comparing the response signal generated by said at least one circuit (21) of the second type to a reference signal, and
- determining whether said wafer (10) operates properly in light of the result of the comparison.
